# EUROPÄISCHE PATENTSCHRIFT

(11) **EP 1 036 683 B1**
(45) Veröffentlichungstag und Bekanntmachung des Hinweises auf die Patenterteilung: **12.05.2004**
(21) Anmeldenummer: 00105074.9
(22) Anmeldetag: 10.03.2000
(51) Int. Cl.: B60J 7/00

(54) **Solardeckel für eine Dachöffnung in einem Fahrzeugdach**
Solar panel for a roof opening of an automotive vehicle
Panneau solaire pour l'ouverture de toit d'un véhicule automobile

(30) Priorität: 17.03.1999 DE 19911811
(43) Veröffentlichungstag der Anmeldung: 20.09.2000
(73) Patentinhaber: Webasto Vehicle Systems International GmbH, 82131 Stockdorf (DE)
(72) Erfinder: Bergmiller, Alexander, 86152 Augsburg (DE)
(74) Vertreter: Wiese, Gerhard

(56) Entgegenhaltungen:
- EP-A- 0 445 427
- EP-A- 0 599 109
- DE-A- 4 105 396
- DE-A- 4 323 140
- DE-C- 19 716 389
- DE-C- 19 739 615
- US-A- 5 154 481
- US-A- 5 213 626

## Beschreibung

Die vorliegende Erfindung betrifft einen Solardeckel für ein Fahrzeugdach gemäß dem Oberbegriff von Anspruch 1 sowie ein Verfahren zum Herstellen desselben gemäß dem Oberbegriff von Anspruch 12.

Aus DE 41 05 396 A1 ist ein gattungsgemäßer Solardeckel bekannt, bei welchem der elastische Folienverbund von zwei transparenten Klebefolien gebildet wird, zwischen welchen die Solarzellen und Leiterbahnen zur elektrischen Verbindung der Solarzellen eingebettet sind. Die Klebefolien und die darin eingebetteten Solarzellen und Leiterbahnen wiederum sind zwischen einer die Deckelscheibe bildenden Glasscheibe und einer von einem Blech gebildeten Trägerschicht eingeschlossen. Das Trägerelement wird von einem Deckelinnenblech gebildet, welches als Profil ausgebildet ist und mit seiner Oberseite in den erhöhten Bereichen an dem Trägerblech des Solarzellenverbunds anliegt. Der Solarzellenverbund erstreckt sich bündig bis zum Rand des Glasdeckels. Direkt am Rand des Trägerblechs des Solarzellenverbunds liegt das Deckelinnenblech nicht an dem Trägerblech an, wobei sich die Umschäumung in diesen Bereich hinein erstreckt. An der Unterseite des Deckelinnenblechs ist ein Funktionsteil eines Verstellmechanismus für den Solardeckel angebracht. Der Solardeckel kann für Schiebedächer, Schiebehebedächer, Spoilerdächer und dergleichen verwendet werden.

Nachteilig bei diesem bekannten Solardeckel ist, daß die Umschäumung nach innen nicht gut abgedichtet ist, denn am inneren Ende der Umschäumung liegen zwei Bleche aufeinander. Eine verbesserte Abdichtung könnte nur mittels eines zusätzlichen Elements, wie z.B. einem Dichtband oder einer Kleberaupe erzielt werden. Dies würde die Fertigung jedoch aufwendiger machen, wodurch zusätzliche Kosten durch eine erhöhte Fertigungszeit und ein zusätzliches Bauteil sowie zusätzliches Werkzeug zur Aufbringung des Dichtmediums bzw. - bauteils entstehen würden.

Die DE 43 23 140 A1 offenbart einen lichtdurchlässigen Solar-Scheibenaufbau für Fahrzeuge, der eine hohe Stabilität bei geringer Bauhöhe und einer genannten Energieausbeute ermöglicht. Die Solarzellen sind von einer Klebefolie bedeckt, die von einer transparenten Abdeckung bedeckt ist, welche einen über die Solarzellen nach außen hinausragenden Auslaufbereich aufweist. Sowohl der Auslaufbereich als auch das innere Ende eines Deckelinnenblechs sind in eine Kunststoff-Schicht eingeschäumt, die von einem Einfaßrahmen für die Scheibe ausgeht. Die Kunststoff-Schicht weist zwischen dem inneren Ende des Deckelinnenblechs und dem Auslaufbereich der Abdeckung eine beträchtliche Dicke auf.

Es ist Aufgabe der vorliegenden Erfindung, einen Solardeckel, welcher möglichst ohne zusätzliche Kosten besser abgedichtet ist, sowie ein Verfahren zur Herstellung desselben zu schaffen. Diese Aufgabe wird durch einen Solardeckel gemäß Anspruch 1 bzw. durch ein Verfahren zum Herstellen eines Solardeckels gemäß Anspruch 12 gelöst. Vorteilhafte Ausgestaltungen der Erfindung sind den Unteransprüchen zu entnehmen.

Bei dieser erfindungsgemäßen Lösung ist vorteilhaft, daß der elastische Auslaufbereich des ausschließlich aus elastischen Folien gebildeten elastischen Folienverbunds als Dichtungselement zwischen dem Trägerelement und der Deckelscheibe wirkt, wodurch die Umschäumung nach innen abgedichtet wird, ohne daß ein zusätzliches Bauteil verwendet werden müßte, welches den Fertigungsaufwand erhöhen würde.

In vorteilhafter Ausgestaltung der Erfindung ist vorgesehen, daß das Trägerelement mit einer Dichtsicke versehen ist, die auf den Auslaufbereich des Folienverbundes drückt. Dadurch kann die Dichtwirkung verbessert werden.

Vorzugsweise endet der Auslaufbereich des Folienverbundes bereits vor dem Rand der Deckelscheibe und des Trägerelements, wobei sich dann vorzugsweise die Umschäumung im Randbereich in den Bereich zwischen der Deckelscheibe und dem Trägerelement hinein erstreckt, vorzugsweise bis zum äußeren Ende des Auslaufbereichs des Folienverbundes. Dadurch wird eine möglichst sichere Verbindung zwischen der Deckelscheibe und dem Trägerelement gewährleistet.

Aus Schutzzwecken und/oder ästhetischen Gründen wird die unterste Lage des Folienverbunds vorzugsweise von einer elastischen Abdeckfolie gebildet. Ferner umfaßt der Folienverbund vorzugsweise zwei elastische Klebefolien, zwischen welchen die Solarzellen eingebettet sind.

Das Trägerelement ist vorzugsweise einstückig ausgebildet und erstreckt sich im wesentlichen über den gesamten Umfangsrandbereich der Deckelscheibe. Die Deckelscheibe ist vorzugsweise als Glasscheibe ausgebildet, während das Trägerelement vorzugsweise als Blechprofil ausgebildet ist.

Der Solardeckel ist insbesondere für ein Schiebedach, Hebedach, Schiebe-Hebe-Dach oder Spoilerdach bestimmt.

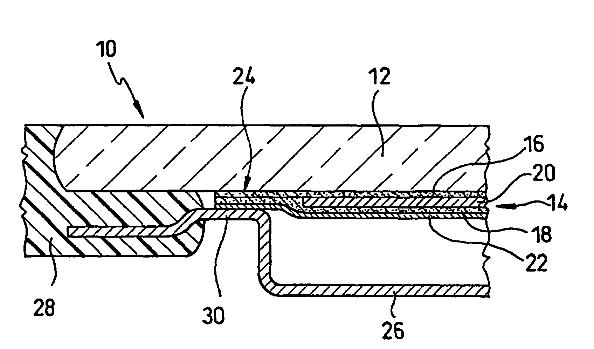

Im folgenden wird eine Ausführungsform der Erfindung anhand der beigefügten Zeichnung näher erläutert, welche eine Schnittansicht durch den Randbereich eines Solardeckels ist.

Der in der einzigen Figur dargestellte Solardeckel 10 umfaßt eine vorzugsweise als transparente Glasscheibe 12 ausgebildete Deckelscheibe, auf deren Unterseite ein Solarzellenverbund 14 mittels einer Klebefolie 16 aufgeklebt ist. Zwischen der Klebefolie 16 und einer weiteren Klebefolie 18 sind mehrere Solarzellen 20 eingebettet. Die Klebefolien 16 und 18 sind transparent und elastisch. Auf der Unterseite der unteren Klebefolie 18 ist eine elastische Abdeckfolie 22 aufgeklebt, um den Solarzellenverbund 14 zu schützen. Aus ästhetischen Gründen kann die Abdeckfolie 22 undurchsichtig sein.

Die beiden Klebefolien 16 und 18 und die Abdeckfolie 22 bilden zusammen einen elastischen Folienverbund, der einen Auslaufbereich 24 aufweist, welcher sich nach außen über die Solarzellen 20 hinaus erstreckt. Im Umfangs- bzw. Außenrandbereich der Deckelscheibe 12 ist ein einstückiges oder alternativ auch mehrteiliges Trägerelement 26 unterhalb der Deckelscheibe 12 vorgesehen, welches dazu dient, den Deckel 10 beispielsweise mit Funktionsteilen einer Verstellmechanik zu verbinden. Das Trägerelement 26 ist als vorzugsweise einstückiges Blechprofil (sogenanntes Deckelinnenblech) ausgebildet und erstreckt sich im wesentlichen über den gesamten Umfangsrandbereich der Deckelscheibe 12. Das Trägerelement 26 ist gemeinsam mit der Glasscheibe 12 am Außenrand mit einer Umschäumung 28 umschäumt, die beispielsweise aus Polyurethan (PU) bestehen kann. Das Trägerelement 26 und die Deckelscheibe 12 sind dabei in vertikalem Abstand zueinander angeordnet, wobei sich die Umschäumung 28 im Randbereich auch in den Bereich zwischen der Deckelscheibe 12 und dem Trägerelement 26 hinein erstreckt. Im mittleren Bereich des Trägerelements bzw. Blechprofils 26 ist eine erhöhte, umlaufende Dichtsicke 30 ausgebildet, welche auf den Auslaufbereich 24 des Folienverbunds drückt. Die Umschäumung 28 erstreckt sich in dem Zwischenraum zwischen der Deckelscheibe 12 und dem Trägerelement 26 von dem Randbereich her, d.h. von außen, bis zu dem äußeren Ende des Auslaufbereichs 24 des Folienverbunds. Der vertikale Abstand zwischen dem Trägerelement 26 und der Deckelscheibe 12 ist so gewählt, daß der Auslaufbereich 24 des Folienverbunds dichtend zwischen der Dichtsicke 30 des Trägerelements 26 und der Unterseite der Deckelscheibe 12 eingeklemmt, d.h. gequetscht, ist, um die Umschäumung 28 nach innen abzudichten. Die Ränder der Deckelscheibe 12 und des Trägerelements 26 sind im wesentlichen bündig angeordnet.

Die Elastizität des Auslaufbereichs 24 des Folienverbunds sorgt einerseits für eine Dichtwirkung zwischen der Deckelscheibe 12 und dem Trägerelement 26, und andererseits dient sie dazu, Toleranzen sowohl des Trägerelements 26 als auch der Deckelscheibe 12 abzufangen bzw. auszugleichen, so daß die Dichtwirkung innerhalb gewisser Schwankungsbreiten vollständig erhalten bleibt. Dadurch müssen die entsprechenden Teile nicht übermäßig präzise gefertigt werden, wodurch die Menge an Ausschuß verringert werden kann, was die Herstellungskosten senkt. Ferner wird durch den elastischen Auslaufbereich 24 des Folienverbunds gewährleistet, daß das Trägerelement mit nicht zu großem Druck gegen die Deckelscheibe 12 gepreßt wird.

Bei der Herstellung des Solardeckels wird wie folgt vorgegangen: Auf die Deckelscheibe 12 wird zunächst an ihrer Unterseite der Solarzellenverbund 14 mittels der oberen Klebefolie 16 angebracht. Anschließend wird das Trägerelement 26 auf bzw. an die Unterseite der Deckelscheibe 12 bzw. des Solarzellenverbunds 14 gelegt, wobei die Dichtsicke 30 des Trägerelements 26 an dem elastischen Auslaufbereich 24 des Solarzellenverbunds 14 zu liegen kommt. Dabei befinden sich die Deckelscheibe 12 und das Trägerelement 26 in einem entsprechenden Schäumwerkzeug, in welchem nun die Umschäumung des Randbereichs der Deckelscheibe 12 und des Trägerelements 26 erfolgt. Der vertikale Abstand zwischen der Deckelscheibe 12 und dem Trägerelement 26 wird dabei so gewählt, daß der Auslaufbereich 24 des Solarzellenverbunds 14 dichtend zwischen der Dichtsicke 30 des Trägerelements 26 und der Deckelscheibe eingeklemmt wird, um die gebildete Umschäumung 28 nach innen abzudichten. Im Formwerkzeug wird dabei bevorzugt eine Lage der Deckelscheibe 12 gewählt, die der umgekehrten Gebrauchslage entspricht, d.h. auf die dann obenliegende Unterseite der Deckelscheibe wird der Solarzellenverbund mittels der Klebefolie 16 aufgeklebt und anschließend des Trägerelement 26 von oben her mit der Dichtsicke 30 auf den Auslaufbereich 24 aufgelegt.

In der vorstehenden Beschreibung und den Ansprüchen ist "außen" als eine Richtung zu verstehen, die von der Mitte der Deckelscheibe 12 zu ihrem Umfangsrand hin verläuft (in der Figur links), während "innen" eine Richtung bezeichnet, die von dem Umfangsrand der Deckelscheibe 12 zu deren Zentrum hin weist (in der Figur rechts).

### Bezugszeichenliste

- Solardeckel: **10**
- Deckelscheibe: **12**
- Solarzellenverbund: **14**
- Klebefolien: **16, 18**
- Solarzellen: **20**
- Abdeckfolie: **22**
- Auslaufbereich: **24**
- Trägerelement (Deckelinnenblech): **26**
- Umschäumung: **28**
- Dichtsicke: **30**

## Patentansprüche

1. Solardeckel für eine Dachöffnung in einem Fahrzeugdach, mit einer transparenten Deckelscheibe (12), an deren Unterseite ein Solarzellenverbund (14) angeordnet ist, der in einen elastischen Folienverbund (16, 18, 22) eingebettete Solarzellen (20) umfaßt, wobei der elastische Folienverbund (16, 18, 22) einen elastischen Auslaufbereich (24) aufweist, der sich nach außen über die Solarzellen (20) hinaus erstreckt, und mit einem Trägerelement (26), welches mittels einer Umschäumung (28) an dem Außenrand der Deckelscheibe (12) an der Unterseite der Deckelscheibe (12) befestigt ist,
**dadurch gekennzeichnet, daß**
der elastische Folienverbund (16, 18, 22) ausschließlich aus elastischen Folien gebildet ist und
die Umschäumung (28) nach innen durch den elastischen Auslaufbereich (24) dadurch abgedichtet ist, daß der elastische Auslaufbereich (24) dichtend durch das Trägerelement (26) und die Deckelscheibe (12) eingeklemmt ist.

2. Solardeckel nach Anspruch 1, **dadurch gekennzeichnet, daß** das Trägerelement (26) mit einer Dichtsicke (30) versehen ist, die am Auslaufbereich (24) des Folienverbunds (16, 18, 22) anliegt.

3. Solardeckel nach Anspruch 1 oder 2, **dadurch gekennzeichnet, daß** der Auslaufbereich (24) des Folienverbunds (16, 18, 22) bereits vor dem Rand der Deckelscheibe (12) und des Trägerelements (26) endet.

4. Solardeckel nach Anspruch 3, **dadurch gekennzeichnet, daß** sich die Umschäumung (28) im Randbereich in den Bereich zwischen der Deckelscheibe (12) und dem Trägerelement (26) hinein erstreckt.

5. Solardeckel nach Anspruch 4, **dadurch gekennzeichnet, daß** sich die Umschäumung (28) von außen bis zu dem äußeren Ende des Auslaufbereichs (24) des Folienverbunds (16, 18, 22) erstreckt.

6. Solardeckel nach einem der vorhergehenden Ansprüche, **dadurch gekennzeichnet, daß** die unterste Lage des Folienverbunds (16, 18, 22) von einer elastischen Abdeckfolie (22) gebildet wird.

7. Solardeckel nach einem der vorhergehenden Ansprüche, **dadurch gekennzeichnet, daß** der Folienverbund (16, 18, 22) zwei elastische Klebefolien (16, 18) aufweist, zwischen welchen die Solarzellen (20) eingebettet sind.

8. Solardeckel nach einem der vorhergehenden Ansprüche, **dadurch gekennzeichnet, daß** das Trägerelement (26) einstückig ausgebildet ist und sich im wesentlichen über den gesamten Umfangsrandbereich der Deckelscheibe (12) erstreckt.

9. Solardeckel nach einem der vorhergehenden Ansprüche, **dadurch gekennzeichnet, daß** die Deckelscheibe (12) als Glasscheibe ausgebildet ist

10. Solardeckel nach einem der vorhergehenden Ansprüche, **dadurch gekennzeichnet, daß** das Trägerelement als Blechprofil (26) ausgebildet ist.

11. Solardeckel nach einem der vorhergehenden Ansprüche, **dadurch gekennzeichnet, daß** der Solardeckel für ein Schiebedach, Hebedach, Schiebe-Hebe-Dach oder Spoilerdach bestimmt ist.

12. Verfahren zum Herstellen eines Solardeckels für eine Dachöffnung in einem Fahrzeugdach nach einem der Ansprüche 1 bis 11, wobei im Zuge des Verfahrens:
a) ein Solarzellenverbund (14), der in einen ausschließlich aus elastischen Folien gebildeten elastischen Folienverbund (16, 18, 22) eingebettete Solarzellen (20) umfaßt, an der Unterseite einer transparenten Deckelscheibe (12) befestigt wird, wobei der elastische Folienverbund einen elastischen Auslaufbereich (24) umfaßt, der sich nach außen über die Solarzellen (20) hinaus erstreckt,
b) ein Trägerelement (26) an die Unterseite der Deckelscheibe (12) gebracht wird, wobei das Trägerelement den elastischen Auslaufbereich (24) mindestens zum Teil überdeckt, und
c) das Trägerelement (26) und die Deckelscheibe (12) im Randbereich mittels einer Umschäumung (28) umschäumt werden, wodurch das Trägerelement (26) an der Unterseite der Deckelscheibe (12) befestigt wird, wobei
d) der vertikale Abstand zwischen der Deckelscheibe (12) und dem Trägerelement 26) so gewählt wird, daß der elastische Auslaufbereich (24) dichtend zwischen dem Trägerelement (26) und der Deckelscheibe (12) eingeklemmt ist, um die Umschäumung (28) nach innen abzudichten.

## Claims

1. Solar cover for a roof opening in a motor vehicle roof, comprising a transparent cover panel (12) on whose underside a solar cell composite (14) is located, the solar cell composite comprising solar cells (20) which are embedded in an elastic film composite (16, 18, 22), the elastic film composite (16, 18, 22) having an elastic transition area (24) which extends outwards beyond the solar cells (20), and comprising a carrier element (26) which is fixed by means of peripheral foam (28) to the outer edge of the cover panel (12) on the underside of the cover panel (12), **characterized in that** the elastic film composite (16, 18, 22) is formed exclusively from elastic films and the peripheral foam (28) is sealed relative to the inside by the elastic transition area (24), the elastic transition area (24) being clamped in a sealing manner by the carrier element (26) and the cover panel (12).

2. Solar cover according to Claim 1, **characterized in that** the carrier element (26) is provided with a sealing bead (30) which bears on the transition area (24) of the film composite (16, 18, 22).

3. Solar cover according to Claim 1 or 2, **characterized in that** the transition area (24) of the film composite (16, 18, 22) ends in front of the edge of the cover panel (12) and of the carrier element (26).

4. Solar cover according to Claim 3, **characterized in that**, in the edge area, the peripheral foam (28) extends into the area between the cover panel (12) and the carrier element (26).

5. Solar cover according to Claim 4, **characterized in that** the peripheral foam (28) extends from the outside as far as the outer end of the transition area (24) of the film composite (16, 18, 22).

6. Solar cover according to one of the preceding claims, **characterized in that** the lowest layer of the film composite (16, 18, 22) is formed by an elastic cover film (22).

7. Solar cover according to one of the preceding claims, **characterized in that** the film composite (16, 18, 22) has two elastic adhesive films (16, 18) between which the solar cells (20) are embedded.

8. Solar cover according to one of the preceding claims, **characterized in that** the carrier element (26) is formed in one piece and extends substantially over the entire peripheral edge area of the cover panel (12).

9. Solar cover according to one of the preceding claims, **characterized in that** the cover panel (12) is formed as a pane of glass.

10. Solar cover according to one of the preceding claims, **characterized in that** the carrier element is formed as a sheet metal profile (26).

11. Solar cover according to one of the preceding claims, **characterized in that** the solar cover is intended for a sliding roof, a lifting roof, a sliding and lifting roof or a spoiler roof.

12. Method of producing a solar cover for a roof opening in a motor vehicle roof according to one of Claims 1 to 11, in the course of the method:
a) a solar cell composite (14), which comprises solar cells (20) which are embedded in a elastic film composite (16, 18, 22) formed exclusively of elastic films, being fixed to the underside of a transparent cover panel (12), the elastic film composite comprising an elastic transition area (24), which extends outwards beyond the solar cells;
b) a carrier element (26) being fitted to the underside of the cover panel (12), the carrier element at least partially covering the elastic transition area (24), and
c) the carrier element (26) and the cover panel (12) preferably being foamed in the edge area by means of a peripheral foam (28), the carrier element (26) thereby being fixed to the underside of the cover panel (12),
d) the vertical distance between the cover panel (12) and the carrier element (26) being selected such that the elastic transition area (24) is clamped in a sealing manner between the carrier element (26) and the cover panel (12), to seal off the peripheral foam (28) relative to the inside.

## Revendications

1. Panneau solaire pour une ouverture pratiquée dans un toit de véhicule, comprenant un vitrage transparent de recouvrement (12) à la face inférieure duquel se trouve un ensemble (14) de cellules solaires englobant des cellules solaires (20) intégrées dans un assemblage de feuilles élastiques (16, 18, 22), ledit assemblage de feuilles élastiques (16, 18, 22) présentant une zone élastique d'expiration (24) s'étendant vers l'extérieur au-delà des cellules solaires (20) ; et un élément de support (26) fixé au bord extérieur du vitrage de recouvrement (12) au moyen d'un enrobage en mousse (28), à la face inférieure dudit vitrage de recouvrement (12),
**caractérisé par le fait que**
l'assemblage de feuilles élastiques (16, 18, 22) est exclusivement constitué de feuilles élastiques ; et
l'étanchéité de l'enrobage en mousse (28), vers l'intérieur, est assurée par la zone élastique d'expiration (24) du fait que ladite zone élastique d'expiration (24) est coincée par l'élément de support (26) et par le vitrage de recouvrement (12), avec effet d'étanchement.

2. Panneau solaire selon la revendication 1, **caractérisé par le fait que** l'élément de support (26) est pourvu d'une moulure d'étanchement (30) appliquée contre la zone d'expiration (24) de l'assemblage de feuilles (16, 18, 22).

3. Panneau solaire selon la revendication 1 ou 2, **caractérisé par le fait que** la zone d'expiration (24) de l'assemblage de feuilles (16, 18, 22) s'achève bien avant le bord du vitrage de recouvrement (12) et de l'élément de support (26).

4. Panneau solaire selon la revendication 3, **caractérisé par le fait que** l'enrobage en mousse (28) pénètre, dans la zone marginale, dans la région située entre le vitrage de recouvrement (12) et l'élément de support (26).

5. Panneau solaire selon la revendication 4, **caractérisé par le fait que** l'enrobage en mousse (28) s'étend, depuis l'extérieur, jusqu'à l'extrémité externe de la zone d'expiration (24) de l'assemblage de feuilles (16, 18, 22).

6. Panneau solaire selon l'une des revendications précédentes, **caractérisé par le fait que** la couche inférieure extrême de l'assemblage de feuilles (16, 18, 22) est matérialisée par une feuille élastique de recouvrement (22).

7. Panneau solaire selon l'une des revendications précédentes, **caractérisé par le fait que** l'assemblage de feuilles (16, 18, 22) comporte deux feuilles adhésives élastiques (16, 18) entre lesquelles les cellules solaires (20) sont intégrées.

8. Panneau solaire selon l'une des revendications précédentes, **caractérisé par le fait que** l'élément de support (26) est de réalisation monobloc et s'étend, pour l'essentiel, sur toute la région marginale périphérique du vitrage de recouvrement (12).

9. Panneau solaire selon l'une des revendications précédentes, **caractérisé par le fait que** le vitrage de recouvrement (12) est réalisé sous la forme d'un panneau de verre.

10. Panneau solaire selon l'une des revendications précédentes, **caractérisé par le fait que** l'élément de support est réalisé sous la forme d'un profilé en tôle (26).

11. Panneau solaire selon l'une des revendications précédentes, **caractérisé par le fait que** ledit panneau solaire est destiné à un toit coulissant, à un toit levable, à un toit coulissant et levable, ou à un becquet.

12. Procédé de fabrication d'un panneau solaire destiné à une ouverture pratiquée dans un toit de véhicule, selon l'une des revendications 1 à 11, procédé au cours duquel :
a) un ensemble (14) de cellules solaires, englobant des cellules solaires (20) intégrées dans un assemblage de feuilles élastiques (16, 18, 22) exclusivement constitué de feuilles élastiques, est fixé à la face inférieure d'un vitrage transparent de recouvrement (12), ledit assemblage de feuilles élastiques comportant une zone élastique d'expiration (24) qui s'étend, vers l'extérieur, au-delà des cellules solaires (20),
b) un élément de support (26) est installé à la face inférieure du vitrage de recouvrement (12), ledit élément de support recouvrant au moins en partie la zone élastique d'expiration (24), et
c) l'élément de support (26) et le vitrage de recouvrement (12) sont noyés par moussage dans la zone marginale, au moyen d'un enrobage en mousse (28), ce qui fixe ledit élément de support (26) à la face inférieure dudit vitrage de recouvrement (12), sachant que
d) la distance verticale, entre le vitrage de recouvrement (12) et l'élément de support (26), est choisie de façon telle que la zone élastique d'expiration (24) soit coincée avec effet d'étanchement entre ledit élément de support (26) et ledit vitrage de recouvrement (12) afin d'assurer, vers l'intérieur, l'étanchéité de l'enrobage en mousse (28).
